# EUROPEAN PATENT APPLICATION

(11) **EP 4 310 883 A1**
(43) Date of publication of application: **24.01.2024**
(21) Application number: 22810983.1
(22) Date of filing: 25.03.2022
(51) Int. Cl.: H01J 37/073

(54) **ELECTRON GUN, ELECTRON BEAM APPLYING EQUIPMENT AND AN ELECTRON BEAM EMISSION METHOD**

(30) Priority: 26.05.2021 JP 2021088245
(71) Applicant: Photo Electron Soul Inc., Nagoya-shi, Aichi 460-0008 (JP)
(72) Inventor: NISHITANI, Tomohiro, Nagoya-shi, Aichi 460-0008 (JP)
(74) Representative: Heyerhoff Geiger GmbH & Co. KG
(86) International application number: PCT/JP2022/014226
(87) International publication number: WO 2022/249707

(57) **Abstract**

Provided is an electron gun that can have a setting to make it possible to irradiate a desired location on an irradiation target with an electron beam having a desired electron beam parameter by using only the component included in the electron gun. This object can be achieved by an electron gun including: a light source; a photocathode configured to generate releasable electrons in response to receiving light from the light source; an anode configured to generate an electric field between the photocathode and the anode, extract the releasable electrons by the generated electric field, and form an electron beam; and a control unit, and the control unit sets the number of emission times of the electron beam and sets an electron beam parameter for each emitting electron beam, or sets an emission duration of the electron beam and sets an electron beam parameter of an emitting electron beam in association with the emission duration.

## Description

### [Technical Field]

The disclosure in the present application relates to an electron gun, an electron beam applicator, and an emission method of an electron beam.

### [Background Art]

An electron gun equipped with a photocathode, electron beam applicators such as an electron microscope, a free electron laser accelerator, an inspection device, or the like including the electron gun (hereafter, a device which is an electron beam applicator excluding an electron gun therefrom may be referred to as a "counterpart device") are known. For example, Patent Literature 1 discloses an electron microscope device with a photocathode that emits an electron beam in response to being irradiated with excitation light from a light source.

Patent Literature 2 discloses a sample inspection device as another example of electron beam applicators with photocathodes configured to emit an electron beam. In the sample inspection device disclosed in Patent Literature 2, it is known to adjust the light amount of pulsed light because of a situation where samples are likely to be thermally damaged or the like.

Further, in electron beam applicators such as an electron microscope device or an electron beam inspection device, it is known to adjust the intensity of an electron beam by using a component on the electron gun side regardless of the configuration of the counterpart device. For example, Patent Literature 3 discloses adjusting the intensity of an electron beam emitted from a photocathode by using an electron beam shielding member that can block a part of the electron beam, a measuring unit that uses a measuring electron beam blocked by the electron beam shielding member to measure a change in the intensity of the electron beam emitted from the photocathode due to deterioration of the photocathode, and a control unit.

### [Citation List]

### [Patent Literature]

Patent Literature 1: Japanese Patent Application Laid-Open No. 2002-313273
Patent Literature 2: Japanese Patent No. 6604649
Patent Literature 3: Japanese Patent No. 6578529

### [Summary of Invention]

### [Technical Problem]

In electron beam applicators, a target to be irradiated with an electron beam (hereafter, also referred to as "irradiation target") may be required to be irradiated with an electron beam having a desired intensity or the like (hereafter, also referred to as "electron beam parameter"). Further, various types of electron guns are known, such as electron guns with a thermionic cathode or a field emitter in addition to electron guns with a photocathode. Thus, a case where an electron gun with a photocathode is newly mounted on a counterpart device on which an electron gun with a thermionic cathode or a field emitter is mounted is also expected.

It is therefore desirable to be able to have a setting to make it possible to irradiate an irradiation target with an electron beam having a desired electron beam parameter by using only the component of an electron gun including a photocathode. Further, to further improve the function of an electron beam applicator, it is desirable to be able to have a setting to make it possible to irradiate a desired location on the same irradiation target with an electron beam having a desired electron beam parameter in addition to irradiating each irradiation target with an electron beam having a desired electron beam parameter.

However, the art disclosed in Patent Literature 2 merely maintains the light amount per unit time of pulsed light constant or gradually increases or reduces the light amount per unit time of pulsed light in accordance with the type of a sample. Further, Patent Literature 2 relates to an art as an electron beam applicator.

The art disclosed in Patent Literature 3 relates to feedback control to adjust a change in the intensity of an electron beam due to deterioration of a photocathode by using a measuring electron beam blocked by a shielding member. Therefore, the art disclosed in Patent Literature 3 also has a problem of inability of irradiating a desired location on an irradiation target with an electron beam having a desired electron beam parameter.

There has been neither an electron gun nor an irradiation method so far that can have a setting to make it possible to irradiate a desired location on an irradiation target with an electron beam having a desired electron beam parameter by using only the component included in the electron gun.

The present application has been made to solve the problem described above, and through an intensive study, it has been newly found that it is possible to solve the problem described above by an electron gun having a control unit that (1) sets the number of emission times of an electron beam and sets an electron beam parameter for each emitting electron beam or (2) sets an emission duration of an electron beam and sets electron beam parameters of emitting electron beams in association with the emission duration.

The disclosure in the present application is to provide an electron gun that can have a setting to make it possible to irradiate a desired location on an irradiation target with an electron beam having a desired electron beam parameter by using only the component included in the electron gun, an electron beam applicator on which the electron gun is mounted, and an emission method of an electron beam.

### [Solution to Problem]

The present application relates to an electron gun, an electron beam applicator, and an emission method of an electron beam illustrated as follows.

(1) An electron gun comprising:
   a light source;
   a photocathode configured to generate releasable electrons in response to receiving light from the light source;
   an anode configured to generate an electric field between the photocathode and the anode, extract the releasable electrons by the generated electric field, and form an electron beam; and
   a control unit,
   wherein the control unit
   sets the number of emission times of the electron beam and sets an electron beam parameter for each emitting electron beam, or
   sets an emission duration of the electron beam and sets an electron beam parameter of an emitting electron beam in association with the emission duration.
(2) The electron gun according to (1) above,
   wherein the control unit sets the number of emission times of the electron beam and sets an electron beam parameter for each emitting electron beam, and
   wherein the electron beam parameter includes at least one selected from an intensity of an electron beam, a level of acceleration energy of an electron beam, a size of an electron beam, a shape of an electron beam, an emission duration of an electron beam, and an emittance of an electron beam.
(3) The electron gun according to (2) above,
   wherein the number of emission times is two or greater, and
   wherein the control unit performs control such that at least one electron beam parameter differs from one selected from the remaining electron beam parameters when emitting an electron beam the set number of times.
(4) The electron gun according to (1) above,
   wherein the control unit sets an emission duration of the electron beam and sets an electron beam parameter of an emitting electron beam in association with the emission duration, and
   wherein the electron beam parameter includes at least one selected from an intensity of an electron beam, a level of acceleration energy of an electron beam, a size of an electron beam, a shape of an electron beam, and an emittance of an electron beam.
(5) The electron gun according to (4) above, wherein the control unit performs control such that the duration includes durations to emit the electron beams with the different beam parameters when emitting electron beams in the set emission duration.
(6) The electron gun according to any one of (1) to (5) above, wherein two or more different locations on the photocathode are irradiated with excitation light from light source so that two or more electron beams are extracted from the photocathode.
(7) An electron beam applicator including the electron gun according to any one of (1) to (6) above, wherein the electron beam applicator is:
   a free electron laser accelerator,
   an electron microscope,
   an electron holography device,
   an electron beam drawing device,
   an electron diffractometer,
   an electron beam inspection device,
   an electron beam metal additive manufacturing device,
   an electron beam lithography device,
   an electron beam processing device,
   an electron beam curing device,
   an electron beam sterilization device,
   an electron beam disinfection device,
   a plasma generation device,
   an atomic element generation device,
   a spin-polarized electron beam generation device,
   a cathodoluminescence device, or
   an inverse photoemission spectroscopy device.
(8) An emission method of an electron beam,
   wherein the electron beam is emitted from an electron gun including
   a light source,
   a photocathode configured to generate releasable electrons in response to receiving light from the light source,
   an anode configured to generate an electric field between the photocathode and the anode, extract the releasable electrons by the generated electric field, and form an electron beam, and
   a control unit, and
   wherein the control unit is configured to
   set the number of emission times of the electron beam and set an electron beam parameter for each emitting electron beam, or
   set an emission duration of the electron beam and set an electron beam parameter of an emitting electron beam in association with the emission duration,
   the emission method comprising:
      an electron beam emission step of forming an electron beam by irradiating the photocathode with excitation light from the light source and extracting releasable electrons generated by the photocathode in response to receiving the excitation light by using an electric field generated between the photocathode and the anode,
      wherein control unit performs control in the electron beam emission step such that an emitting electron beam has the set electron beam parameter.
(9) The emission method according to (8) above,
   wherein the control unit is configured to set the number of emission times of the electron beam and set an electron beam parameter for each emitting electron beam, and
   wherein the electron beam parameter includes at least one selected from an intensity of an electron beam, a level of acceleration energy of an electron beam, a size of an electron beam, a shape of an electron beam, an emission duration of an electron beam, and an emittance of an electron beam.
(10) The emission method according to (9) above,
   wherein the number of emission times is two or greater, and
   wherein the control unit performs control such that at least one electron beam parameter differs from one selected from the remaining electron beam parameters when emitting an electron beam the set number of times.
(11) The emission method according to (8) above,
   wherein the control unit is configured to set an emission duration of the electron beam and set an electron beam parameter of an emitting electron beam in association with the emission duration, and
   wherein the electron beam parameter includes at least one selected from an intensity of an electron beam, a level of acceleration energy of an electron beam, a size of an electron beam, a shape of an electron beam, and an emittance of an electron beam.
(12) The emission method according to (11) above, wherein the control unit performs control such that the duration includes durations to emit the electron beams with different beam parameters when emitting electron beams in the set emission duration.

### [Advantageous Effects]

The electron gun disclosed in the present application can have a setting to make it possible to irradiate a desired location on an irradiation target with an electron beam having a desired electron beam parameter.

### [Brief Description of Drawings]

[FIG. 1] FIG. 1 is a diagram schematically illustrating an electron gun 1A according to a first embodiment and a counterpart device E on which the electron gun 1A is mounted.
[FIG. 2] FIG. 2 is a diagram illustrating an overview of a control unit 5 of the electron gun 1A.
[FIG. 3] FIG. 3 is a diagram illustrating an overview when an electron beam parameter set by the control unit 5 is controlled.
[FIG. 4] FIG. 4 is an enlarged view of a portion of the photocathode 3 of an electron gun 1B according to a second embodiment.
[FIG. 5] FIG. 5 is a diagram schematically illustrating an electron gun 1C according to a third embodiment and a counterpart device E on which the electron gun 1C is mounted.
[FIG. 6] FIG. 6 is a diagram schematically illustrating an electron gun 1D according to a fourth embodiment and a counterpart device E on which the electron gun 1D is mounted.
[FIG. 7] FIG. 7A is a photograph substitute for a drawing, which is a SEM image captured in Example 3.
FIG. 7B is a photograph substitute for a drawing, which is a SEM image captured in Example 4.

### [Description of Embodiments]

An electron gun, an electron beam applicator, and an emission method of an electron beam will be described below in detail with reference to the drawings. Note that, in the present specification, members having the same type of functions are labeled with the same or similar references. Further, duplicated description for the members labeled with the same or similar references may be omitted.

Further, the position, size, range, or the like of respective configurations illustrated in the drawings may be depicted differently from the actual position, size, range, or the like for easier understanding. Thus, the disclosure in the present application is not necessarily limited to the position, size, range, or the like disclosed in the drawings.

### [First Embodiment of Electron Gun]

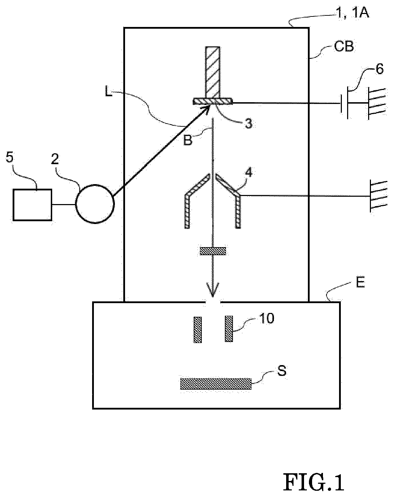

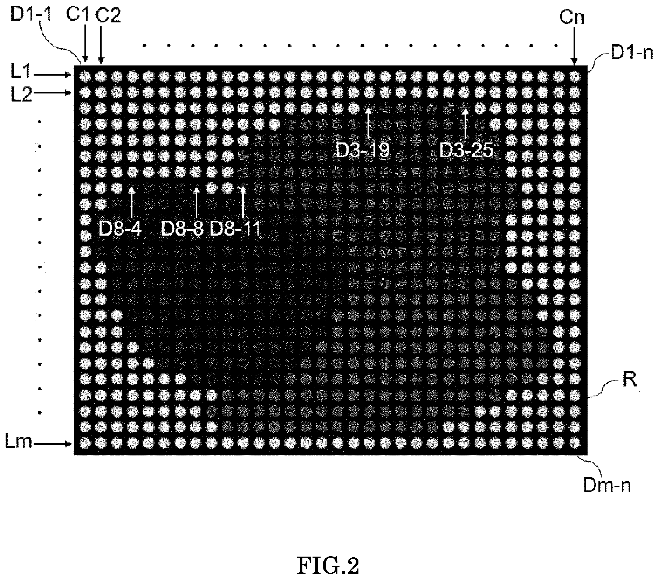

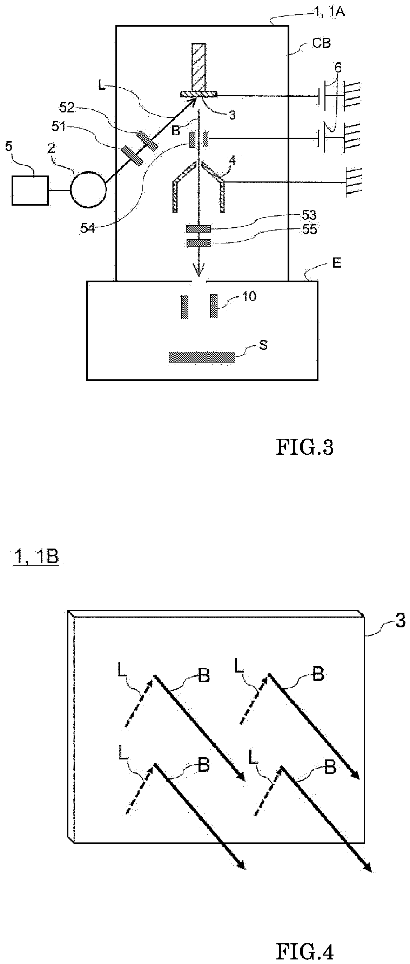

An electron gun 1A according to the first embodiment will be described with reference to FIG. 1 to FIG. 3. FIG. 1 is a diagram schematically illustrating the electron gun 1A according to the first embodiment and a counterpart device E on which the electron gun 1A is mounted. FIG. 2 is a diagram illustrating an overview of a control unit 5 of the electron gun 1A. FIG. 3 is a diagram illustrating an overview when an electron beam parameter set by the control unit 5 is controlled.

The electron gun 1A according to the first embodiment includes at least a light source 2, a photocathode 3, an anode 4, and the control unit 5. The electron gun 1A may optionally and additionally include a power supply 6 for generating an electric field between the photocathode 3 and the anode 4. Further, in the example illustrated in FIG. 1, an electron beam applicator is a SEM, and the counterpart device E includes an electron beam deflector 10. The electron beam deflector 10 is used to scan a sample S with the electron beam B emitted from the electron gun 1A. Note that the example illustrated in FIG. 1 is an example of the counterpart device E. Although depiction is omitted, the counterpart device E can have known components in accordance with the type of the electron beam applicator.

The light source 2 is not particularly limited as long as it can irradiate the photocathode 3 with the excitation light L to cause emission of an electron beam B. The light source 2 may be, for example, a high power (watt class), high frequency (several hundred MHz), ultrashort pulse laser light source, a relatively inexpensive laser diode, an LED, or the like. The excitation light L for irradiation can be either pulsed light or continuous light and can be adjusted as appropriate in accordance with purposes. Note that, in the example illustrated in FIG. 1, the light source 2 is arranged outside a vacuum chamber CB, and a first face side (a face on the anode 4 side) of the photocathode 3 is irradiated with the excitation light L. Alternatively, the light source 2 may be arranged inside the vacuum chamber CB. Further, a second face side (a face on the opposite side from the anode 4) of the photocathode 3 may be irradiated with the excitation light L.

The photocathode 3 generates releasable electrons in response to receiving the excitation light L emitted from the light source 2. The principle of the photocathode 3 generating releasable electrons in response to receiving the excitation light L is known (for example, see Japanese Patent No. 5808021 and the like).

The photocathode 3 is formed of a substrate of quartz glass, sapphire glass, or the like and a photocathode film (not illustrated) adhered to the first face (the face on the anode 4 side) of the substrate. The photocathode material for forming the photocathode film is not particularly limited as long as it can generate releasable electrons by being irradiated with excitation light and may be a material requiring EA surface treatment, a material not requiring EA surface treatment, or the like. The material requiring EA surface treatment may be, for example, Group III-V semiconductor materials or Group II-VI semiconductor materials. Specifically, the material may be AlN, Ce₂Te, GaN, a compound of one or more types of alkaline metals and Sb, or AlAs, GaP, GaAs, GaSb, InAs, or the like, and a mixed crystal thereof, or the like. The material may be a metal as another example and specifically may be Mg, Cu, Nb, LaB₆, SeB₆, Ag, or the like. The photocathode 3 can be fabricated by applying EA surface treatment on the photocathode material described above. For the photocathode 3, suitable selection of the semiconductor material or the structure thereof makes it possible not only to select excitation light in a range from near-ultraviolet to infrared wavelengths in accordance with gap energy of the semiconductor but also to achieve electron beam source performance (quantum yield, durability, monochromaticity, time response, spin polarization) suitable for respective uses of the electron beam.

Further, the material not requiring EA surface treatment may be, for example, a single metal, an alloy, or a metal compound of Cu, Mg, Sm, Tb, Y, or the like or diamond, WBaO, Cs₂Te, or the like. The photocathode 3 not requiring EA surface treatment can be fabricated by a known method (for example, see Japanese Patent No. 3537779 or the like). The content disclosed in Japanese Patent No. 3537779 is incorporated in the present specification in its entirety by reference.

Note that, regarding the reference to "photocathode" and "cathode" in the present specification, "photocathode" may be used when the reference in question means emission of the electron beam, and "cathode" may be used when the reference in question means the counter electrode of an "anode". Regarding the reference numeral, however, numeral 3 is used for both cases of "photocathode" and "cathode".

The anode 4 is not particularly limited as long as it can generate an electric field together with the cathode 3, and an anode 4 generally used in the field of electron guns can be used. An electric field is generated between the cathode 3 and the anode 4, thereby releasable electrons generated on the photocathode 3 due to irradiation with the excitation light L are extracted, and the electron beam B is formed.

Although the example in which the power supply 6 is connected to the cathode 3 in order to generate an electric field between the cathode 3 and the anode 4 is illustrated in FIG. 1, the arrangement of the power supply 6 is not particularly limited as long as it causes a potential difference to occur between the cathode 3 and the anode 4.

Next, the control unit 5 of the electron gun 1A according to the first embodiment will be described with reference to FIG. 2 and FIG. 3. FIG. 2 illustrates an example in which the photocathode 3 receives pulsed excitation light L, and the control unit 5 sets the number of emission times of the electron beam B and sets an electron beam parameter (hereafter, also simply referred to as "parameter") for each emitting electron beam B.

The counterpart device E has the electron beam deflector 10 in general that deflects the electron beam B emitted from the electron gun 1A. For example, in the example of the SEM illustrated in FIG. 3, the electron beam deflector 10 scans the sample S (hereafter, a target of the counterpart device E to be irradiated with the electron beam B may be referred to as "irradiation target") with the electron beam B emitted from the electron gun 1A.

The deflection of the electron beam B performed by the electron beam deflector 10 linearly scans an irradiation region R of an irradiation target in general. Thus, the present inventors have newly found that:
(1) based on the size of the irradiation region R, the spot size of the electron beam B in the irradiation region R, the control speed of the electron beam deflector 10 of the counterpart device E, or the like, it is possible to calculate the number of emission times of the electron beam B required in irradiating the irradiation region R; and
(2) with the number of emission times being set, by setting a parameter for each emitting electron beam B, it is possible to irradiate a desired location in the irradiation region R with the electron beam B having a desired parameter in accordance with a setting on the electron gun 1A side.
The disclosure in the present application is based on such a new finding.

The control performed by the control unit 5 will be described in more detail with reference to FIG. 2. In the example illustrated in FIG. 2, the electron beam deflector 10 performs the following control.
(a) Performing irradiation with a pulsed electron beam B emitted by the electron gun 1A from the left end (D1-1) on the first line (L1) toward the right end while deflecting the electron beam B.
(b) After irradiating a spot (Dl-n) at the right end on L1 with the electron beam B, deflecting the irradiation position of the electron beam B to the left end of the second line (L2), and performing irradiation with the electron beam B from the left end toward the right end while deflecting the electron beam B in the same manner as (a) described above.
(c) Repeating (b) described above until irradiation of the final spot (Dm-n) in the irradiation region R with the electron beam B.

In accordance with the procedure described above in (a) to (c), the electron beam B sequentially emitted from the electron gun 1A is run in a plane in the irradiation region R, and it is possible to know that which part of the irradiation region R is irradiated with the electron beam B emitted in which order. It is therefore possible to have a setting by using the component on the electron gun 1A side such that, when the parameter of the electron beam B irradiating the irradiation region D1-1 is denoted as X, D1-1 to D3-18 are irradiated with the electron beam B of a parameter X, and D3-19 to D3-25 are irradiated with the electron beam B of a parameter Y, for example. Further, since the electron gun 1A can emit a pulsed electron beam, it is possible to have a fine setting on the electron gun 1A side such that, as illustrated in FIG. 2, D8-4 to D8-8 are irradiated with the electron beam B of a parameter Z, irradiation with the electron beam B of the parameter X is then performed twice, and subsequently, the position of D8-11 and some subsequent positions are irradiated with the electron beam B of the parameter Y, and the like.

Note that in the present specification, the reference to "an electron beam parameter is set for each emitting electron beam" includes that the control unit 5 collectively sets parameters of the electron beam B for a predetermined number of emission times, in addition to setting parameters such as X, Y, Z, and the like one by one on an emitting electron beam B basis. The setting method performed by the control unit 5 is not particularly limited as long as respective electron beams B are emitted with parameters such as X, Y, Z, and the like.

Further, in the example illustrated in FIG. 2, the control unit 5 performs control such that, when electron beams B are emitted a set number of times (D1-1 to Dm-n), at least one parameter differs from one selected from the remaining parameters. In other words, control is performed such that all the parameters of the electron beams B emitted to D1-1 to Dm-n are not the same as each other. Alternatively, all the parameters of the electron beams B emitted to D1-1 to Dm-n may be set to be the same as long as "an electron beam parameter can be set for each emitting electron beam" by using the control unit 5.

The parameter is not particularly limited as long as it can determine quality of an electron beam. Examples of the parameter may be, but are not limited to, the intensity of an electron beam, the level of acceleration energy of an electron beam, the size of an electron beam, the shape of an electron beam, an emission duration of the electron beam, the emittance of an electron beam, and the like. When all the parameters of the electron beams B irradiating the irradiation region R are not the same as each other, some of the parameters illustrated above as examples can be set different for respective electron beams B. For example, the strength level or the like can be changed for the same type of parameters, such as changing the intensity of an electron beam in one turn from the intensity of an electron beam in another turn or changing the level of the acceleration energy of an electron beam in one turn from the level of the acceleration energy of an electron beam in another turn. Alternatively, different types of parameters may be set, such as changing the size or the shape for only the electron beam B in certain turn.

Obviously, a plurality of parameters may be combined. For example, when the intensity of an electron beam in one turn is defined as 1 and the level of acceleration energy of the electron beam is defined as 1, the intensity of an electron beam in another turn may be set to 1.5 and the level of acceleration energy of the electron beam may be set to 1.5. Further, no electron beam B being emitted (for example, no irradiation of the photocathode 3 with the excitation light L) may be one of the parameters.

An example of control based on parameters set by the control unit 5 will be described with reference to FIG. 3. Note that the following description represents an example of the control. Another control may be employed as long as it falls in the scope of the technical concept disclosed in the present application. Further, to avoid complication of the drawing, a part of description for circuits or components of the control unit 5 may be omitted.

First, the control performed when the set parameter is the intensity of the electron beam B will be described. Note that, in the present specification, "intensity of an electron beam" means the level of the number of electrons included in the electron beam B in irradiation (value of current). The intensity of the electron beam B depends on the light amount of the excitation light L irradiating the photocathode 3. Therefore, when the intensity of the electron beam B is set as a parameter, the control unit 5 can control the light amount of the excitation light L irradiating the photocathode 3 so as to have the set intensity of the electron beam B. In the example illustrated in FIG. 1, the control unit 5 controls the light amount of the light source 2. Alternatively, a light amount adjustment device 51 such as a liquid crystal shutter is provided between the light source 2 and the photocathode 3, and the light amount reaching the photocathode 3 may be controlled by the control of the liquid crystal shutter with the light amount of the light source 2 being maintained constant.

The level of the acceleration energy of the electron beam B can be controlled by changing the electric field intensity between the cathode 3 and the anode 4. The larger the voltage difference between the cathode 3 and the anode 4 is, the larger the acceleration energy will be. Therefore, when the level of the acceleration energy of the electron beam B is set as a parameter, the control unit 5 can control the voltage of the power supply 6 so as to have the set level of the acceleration energy of the electron beam B.

The size of the electron beam B can be controlled by changing the size of the excitation light L irradiating the photocathode 3. The larger the size of the excitation light L is, the larger the size of the electron beam B will be. Therefore, when the size of the electron beam B is set as a parameter, the control unit 5 can control an excitation light size adjustment device 52 such as a lens or a liquid crystal shutter so as to have the set size of the electron beam B. Alternatively, or optionally and additionally, an electron beam size adjustment device 53 such as an electromagnetic lens or an aperture may be provided on the optical axis of the emitted electron beam B, and the control unit 5 may control the electron beam size adjustment device 53. Further alternatively, or optionally and additionally, an intermediate electrode 54 may be provided between the cathode 3 and the anode 4. The control unit 5 can adjust the focus position of the electron beam B when the electron beam B reaches the counterpart device E, in other words, control the size of the electron beam B when the electron beam B reaches the target region R by (1) controlling the power supply 6 to adjust the potential differences between the cathode 3, the intermediate electrode 54, and the anode 4 or (2) controlling motion of the intermediate electrode 54 to adjust the relative positional relationships between the cathode 3, the intermediate electrode 54, and the anode 4. Note that the configuration of the intermediate electrode 54, the control method, and the principle that can control the focus position are described in detail in Japanese Patent No. 6466020. The content disclosed in Japanese Patent No. 6466020 is incorporated in the present application by reference.

The shape of the electron beam B can be controlled by providing an electron beam shape adjustment device 55 such as an electromagnetic lens or an aperture on the optical axis of the emitted electron beam B. Therefore, when the shape of the electron beam B is set as a parameter, the control unit 5 can control the electron beam shape adjustment device 55 so as to have the set shape of the electron beam B.

The emission duration of the electron beam B can be controlled by the emission duration of the excitation light L emitted by the light source 2. Therefore, when the emission duration of the electron beam B is set as a parameter, the control unit 5 can perform ON-OFF control of the light source 2 so as to have the set emission duration of the electron beam B. Alternatively, although depiction is omitted, a shutter may be provided between the light source 2 and the photocathode 3, and the control unit 5 may control the shutter to control the emission duration of the electron beam B.

The emittance of the electron beam B can be controlled by the wavelength of the excitation light L emitted by the light source 2. Therefore, when the emittance of the electron beam B is set as a parameter, the control unit 5 may control the wavelength of the excitation light L so as to have the set emittance of the electron beam B. Although depiction is omitted, a known variable wavelength filter may be provided between the light source 2 and the photocathode 3, and the control unit 5 may control the variable wavelength filter.

The electron gun 1A according to the first embodiment emits the pulsed electron beam B to the counterpart device E. Thus, the electron beam deflector 10 of the counterpart device E can deflect the incident pulsed electron beam B sequentially from D1-1 toward Dm-n, as illustrated in FIG. 2. Therefore, the electron gun 1A according to the first embodiment achieves an advantageous effect of being able to have a setting to make it possible to irradiate a desired location on an irradiation target with the electron beam B having a desired parameter by using only the component included in the electron gun 1A.

### [Modified Example of Control Unit 5]

The control unit 5 described above is illustrated for the example of setting the number of emission times of the electron beam B and setting a parameter for each emitting electron beam B. That is, this is an example expecting that the electron beam B emitted by the electron gun 1A to the counterpart device E is a pulsed electron beam B. Alternatively, the electron beam B emitted by the electron gun 1A to the counterpart device E may be a continuous electron beam B. As illustrated in FIG. 2, the electron beam B that has entered the counterpart device E is used to linearly scan D1-1 to Dm-n by the electron beam deflector 10. Therefore, the emission duration of the electron beam B required to scan the irradiation region R can be calculated based on the size of the irradiation region R, the spot size of the electron beam B in the irradiation region R, the control speed of the electron beam deflector 10 of the counterpart device E, or the like.

When the time corresponding to D1-1 of the irradiation region R illustrated in FIG. 2 is defined as t₁ and the time corresponding to Dm-n is defined as tₘₙ, the continuous electron beam B emitted from the electron gun 1A during time series (t₁ to tₘₙ) is run in a plane in the irradiation region R, and it is possible to know that which part of the irradiation region R is irradiated with the electron beam B emitted at what time.

The control unit 5 according to the modified example sets an emission duration to emit the electron beam B and sets the parameter of the emitting electron beam B in association with the emission duration. In the case of the control unit 5 according to the modified example, the electron beam B that has entered the counterpart device E is deflected continuously from the position of D1-1 to the position of Dm-n illustrated in FIG. 2. It is therefore possible to set the parameters (the intensity of the electron beam, the level of the acceleration energy of the electron beam, the size of the electron beam, the shape of the electron beam, and the emittance of the electron beam) in association with the emission duration except that it is not possible to set the parameter related to the emission duration of an electron beam among the parameters that can be set by the control unit 5 of the first embodiment.

The control unit 5 according to the modified example can perform control based on the parameter set in the same manner as with the control unit 5 according to the first embodiment except for the parameter related to the emission duration of an electron beam. Therefore, the electron gun 1A having the control unit 5 according to the modified example also achieves the advantageous effect of being able to have a setting to make it possible to irradiate a desired location on an irradiation target with the electron beam having a desired parameter by using only the component included in the electron gun 1A.

### [Second Embodiment of Electron Gun]

An electron gun 1B according to the second embodiment will be described with reference to FIG. 1 to FIG. 4. FIG. 4 is an enlarged view of the portion of the photocathode 3 of the electron gun 1B according to the second embodiment.

The electron gun 1B according to the second embodiment differs from the electron gun 1A according to the first embodiment in that two or more different locations on the photocathode 3 are irradiated with the excitation light L from the light source so that two or more electron beams B are extracted from the photocathode 3, and other features are the same as those in the first embodiment. Therefore, for the second embodiment, features different from those in the first embodiment will be mainly described, and repeated description for the features that have already been described in the first embodiment will be omitted. Accordingly, it is apparent that, even when not explicitly described in the second embodiment, any feature that has already been described in the first embodiment can be employed in the second embodiment. Similarly, also for the third and fourth embodiments described later, while duplicated description will be omitted, it is apparent that any feature that has already been described in the preceding embodiments can be employed thereto.

To irradiate two or more different locations on the photocathode 3 with the excitation light L from the light source 2, a plurality of light sources 2 can be provided though depiction thereof is omitted. Alternatively, an excitation light splitting device such as a splitter, a spatial phase modulator, or the like may be used to split the excitation light L from a single light source 2 into two or more to irradiate the photocathode 3.

The electron gun 1B according to the second embodiment can irradiate an irradiation target with a plurality of electron beams B. Therefore, in addition to the advantageous effect achieved by the electron gun 1A according to the first embodiment, the following advantageous effects are achieved.
(1) When the irradiation target is irradiated such that the plurality of electron beams B do not overlap each other, the throughput can be improved.
(2) When the irradiation target is irradiated such that the plurality of electron beams B overlap each other, the detection sensitivity of the counterpart device E is improved, and the machining efficiency is improved.
(3) When the irradiation target is irradiated such that the plurality of electron beams B overlap each other, after irradiation with a pump beam that provides a desired effect to the irradiation target (irradiation duration and charge amount), the irradiation target can be irradiated with a next beam (probe beam) after a while.
(4) Further, when the irradiation target is irradiated such that the plurality of electron beams B overlap each other, the electron beams B can be used for the purpose of charge compensation on the irradiation target.

### [Third Embodiment of Electron Gun]

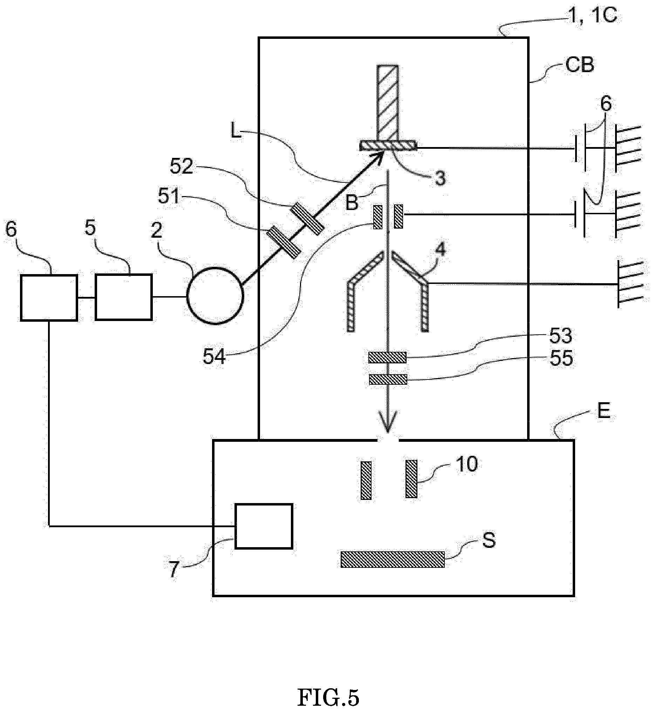

An electron gun 1C according to the third embodiment will be described with reference to FIG. 5. FIG. 5 is a diagram schematically illustrating the electron gun 1C according to the third embodiment and the counterpart device E on which the electron gun 1C is mounted.

The electron gun 1C according to the third embodiment differs from the electron gun 1A according to the first embodiment and the electron gun 1B according to the second embodiment in that the control unit 5 can set a parameter by referencing information from the counterpart device E, and other features are the same as those in the first and second embodiments.

The electron gun 1C according to the third embodiment includes an information display device 6 for referencing information from the counterpart device E. For example, when the electron beam applicator is an electron microscope, the counterpart device E has a detector 7 that detects a signal obtained by irradiating the sample S with the electron beam B. The signal detected by the detector 7 can be displayed on the information display device 6 after processed. In the electron gun 1C according to the third embodiment, the control unit 5 can set a parameter based on information displayed on the information display device 6.

More specifically, in a case of an electron microscope, a captured image of the sample S can be displayed on the information display device 6. Further, in the displayed image, a location intended to enlarge or a location intended to change the intensity or the like of the electron beam B in order to increase the contrast is indicated by a pointer or the like. Based on this indication, the control unit 5 can set the number of emission times of the electron beam B and set a parameter for each emitting electron beam B or can set the emission duration of the electron beam B and set a parameter of the emitting electron beam B in association with the emission duration. The information display device 6 may be a known device such as a liquid crystal display, a CRT display, an organic EL display, an LED display, or the like.

The electron gun 1C according to the third embodiment can set a parameter of the emitting electron beam B after referencing information from the counterpart device E and thus achieves an advantageous effect of being able to set a parameter in more detailed manner in addition to the advantageous effects achieved by the electron guns 1 according to the first and second embodiment.

### [Fourth Embodiment of Electron Gun]

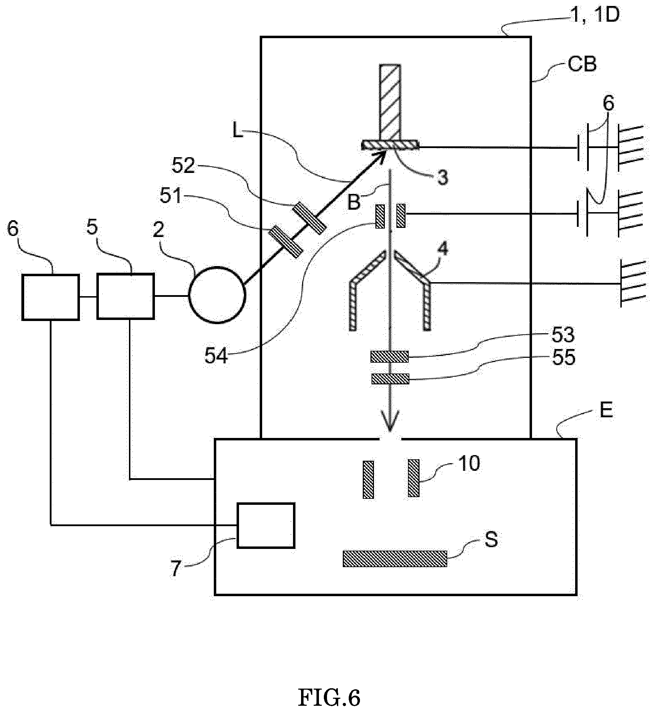

An electron gun 1D according to the fourth embodiment will be described with reference to FIG. 6. FIG. 6 schematically illustrates the electron gun 1D according to the fourth embodiment and the counterpart device E on which the electron gun 1D is mounted.

The electron gun 1D according to the fourth embodiment differs from the electron guns 1A to 1C according to the first to third embodiments in that the control unit 5 also controls the component of the counterpart device E, and other features are the same as those of the electron guns 1A to 1C according to the first to third embodiments.

The control unit 5 of the electron gun 1D according to the fourth embodiment also controls the component of the counterpart device E in association with a set parameter in addition to setting a parameter of the electron beam B to be emitted from the electron gun 1D and controlling the component of the electron gun 1D based on the setting. Therefore, in the example of control based on parameters set by the control unit 5, the following control can be performed, for example.
(1) When the counterpart device E has an electron beam size adjustment device such as an electromagnetic lens or an aperture, the control unit 5 may control the electron beam size adjustment device of the counterpart device E where necessary when controlling the size of the electron beam B.
(2) When the counterpart device E has an electron beam shape adjustment device such as an electromagnetic lens or an aperture, the control unit 5 may control the electron beam shape adjustment device of the counterpart device E where necessary when controlling the shape of the electron beam B.
(3) When the counterpart device E has a mechanical shutter, the control unit 5 may control the mechanical shutter of the counterpart device E where necessary when controlling the emission duration of the electron beam B.
(4) When the counterpart device E has an energy filter, the control unit 5 may control the energy filter of the counterpart device E where necessary when controlling the emittance of the electron beam B.
(5) When a continuous electron beam B is emitted under the control on the electron guns 1A to 1C side, the deflection speed of the electron beam B is in accordance with the setting of the counterpart device E. Therefore, unlike the pulsed electron beam B, it is not possible to set any parameter related to the emission duration of the electron beam B. It is thus not possible to control the length of the duration for irradiating the same location in the irradiation region R with the electron beam B. In contrast, when the control unit 5 controls the electron beam deflector 10 in association with the emission duration, it is possible to control the length of the duration for irradiating the same location in the irradiation region R with the electron beam B by controlling the deflection speed of the electron beam deflector 10. Note that, when the control unit 5 controls the deflection speed of the electron beam deflector 10, the calculation can be performed taking the deflection speed of the electron beam deflector 10 into consideration when setting the emission duration of the electron beam B.
(6) As illustrated in FIG. 2, the electron beam deflector 10 of the counterpart device E linearly scans a region with the incident electron beam B in general. In contrast, when the control unit 5 controls the electron beam deflector 10 in association with the order of the emitting electron beam B or the emission duration of the emitting electron beam B, irradiation with electron beam B having a desired parameter can be performed with a change of the row on a desired location on a single line or performed in desired order on a desired location for the irradiation region R.

The electron gun 1D according to the fourth embodiment can also control the component of the counterpart device E and thus achieves an advantageous effect of more choices being available for the control method of set parameters in addition to the advantageous effects achieved by the electron guns 1A to 1C according to the first to third embodiments.

### [Embodiment of Electron Beam Applicator]

The electron beam applicator E on which the electron gun 1 (1A to 1D) is mounted may be a known device on which an electron gun is mounted. For example, the counterpart device E may be a free electron laser accelerator, an electron microscope, an electron holography device, an electron beam drawing device, an electron diffractometer, an electron beam inspection device, an electron beam metal additive manufacturing device, an electron beam lithography device, an electron beam processing device, an electron beam curing device, an electron beam sterilization device, an electron beam disinfection device, a plasma generation device, an atomic element generation device, a spin-polarized electron beam generation device, a cathodoluminescence device, an inverse photoemission spectroscopy device, or the like.

The electron beam applicator on which the electron gun 1 disclosed in the present application is mounted achieves the following advantageous effects, for example.
(1) Regardless of the type of the electron beam applicator, the parameter of the emitting electron beam B can be set by using only the component on the mounted electron gun 1 side. Therefore, convenience of the electron beam applicator is improved.
(2) In a case of an electron microscope, a sample may be charged up. It is possible to eliminate charge-up of a sample by irradiating a location other than a location intended to capture an image with an electron beam for which parameters, such as the intensity of the electron beam B, the size of the electron beam B, or the like are set.
(3) In a case of an electron microscope, increased acceleration energy of the electron beam B allows electrons to reach a deeper position of a sample. Further, with control of the intensity or the like of the electron beam B, unevenness and the like of the sample become clearer, a conventionally unobservable structure becomes visible.
(4) In a case of an electron microscope, by irradiating a weak signal location with a high-intensity electron beam B and irradiating an excessively strong signal location with a low-intensity electron beam B, it is possible to cause a signal that would otherwise be out of the detection range of a detector with the conventional electron beam B to fall in the detection range.
(5) In a case of an electron beam metal additive manufacturing device (3D printer), the base portion to which a metal is laminated may need to be warmed. It is possible to perform control to increase the intensity of the electron beam B, increase the emission duration of the electron beam B, increase the size of the electron beam B, or the like for only the location intended to warm.
(6) In a case of the electron beam inspection device, it is possible to efficiently perform inspection by selecting a location requiring inspection or configuring a condition setting or the like of inspection and improve the throughput of the inspection.

### [Embodiment of Emission Method of Electron Beam]

An embodiment of an emission method of an electron beam (hereafter, also referred to as "emission method") is performed by using the electron gun 1 according to any of the first to fourth embodiments or the electron beam applicator on which the electron gun 1 according to any of the first to fourth embodiments is mounted.

The emission method according to the embodiment includes an electron beam emission step of forming the electron beam B by irradiating the photocathode 3 with the excitation light L from the light source 2 and extracting releasable electrons generated by the photocathode 3 in response to receiving the excitation light L by using an electric field generated between the photocathode 3 and the anode 4. The control unit 5 of the electron gun 1 (1) can set the number of emission times of the electron beam B and set a parameter for each emitting electron beam B or (2) can set the emission duration of the electron beam B and set a parameter of the emitting electron beam B in association with the emission duration. The control unit 5 then controls the component of the electron gun 1 and also, optionally and additionally, the component of the counterpart device E so that the emitting electron beam B has the set parameter in the electron beam emission step.

### [Embodiment 1 that can be employed by the control unit 5 in the emission method]

When the control unit 5 (1) sets the number of emission times of the electron beam B and sets a parameter for each emitting electron beam B, the parameter can include at least one selected from the intensity of an electron beam, the level of acceleration energy of an electron beam, the size of an electron beam, the shape of an electron beam, an emission duration of an electron beam, and the emittance of an electron beam, for example. The control unit 5 may perform control such that all the parameters of the electron beams are the same or may perform control such that at least one parameter differs from one selected from the remaining parameters when emitting electron beams a set number of times. Further, the control unit 5 may control only the component on the electron gun 1 side or may also control the component of the counterpart device E, as described in the embodiments of the electron gun 1. Since the specific example of control has already been described in the embodiments of the electron gun 1, the detailed description thereof is omitted.

### [Embodiment 2 that can be employed by the control unit 5 in the emission method]

When the control unit 5 (2) sets the emission duration of the electron beam B and sets a parameter of the emitting electron beam B in association with the emission duration, the parameter can include at least one selected from the intensity of an electron beam, the level of acceleration energy of an electron beam, the size of an electron beam, the shape of an electron beam, and the emittance of an electron beam, for example. The control unit 5 may set the emission duration to emit the electron beam B and perform control such that the parameters for the emitting electron beams B are the same or perform control such that include durations to emit electron beams B with different parameters.

While Examples are presented below to specifically describe the embodiment disclosed in the present application, these Examples are only for the purpose of illustration of the embodiment. The Examples neither limit the scope of the invention disclosed in the present application nor express restriction of the same.

### [Examples]

### <Example 1>

### [Fabrication of Electron Gun 1]

A laser light source (iBeamSmart by Toptica) was used for the light source 2. For the photocathode 3, an InGaN photocathode was fabricated by a known method described in Daiki SATO et al. 2016 Jpn. J. Appl. Phys. 55 05FH05. EA treatment on the surface of the photocathode was performed in accordance with a known method. The control unit 5 was programed to be able to set the number of emission times of the electron beam B and to set an electron beam parameter for each emitting electron beam B.

### <Example 2>

### [Fabrication of Electron Beam Applicator (SEM)]

The portion of an electron gun in a commercially available SEM was replaced with the fabricated electron gun 1. Note that, according to the specification of the commercially available SEM, a cold field emission electron source (CFE) is used for the electron gun, and a deflection coil is provided as the electron beam deflector 10. The maximum acceleration voltage of the electron beam is 30 kV, and observation of magnification at a maximum of 1 million times is possible.

### [Emission Method of Electron Beam]

### <Example 3>

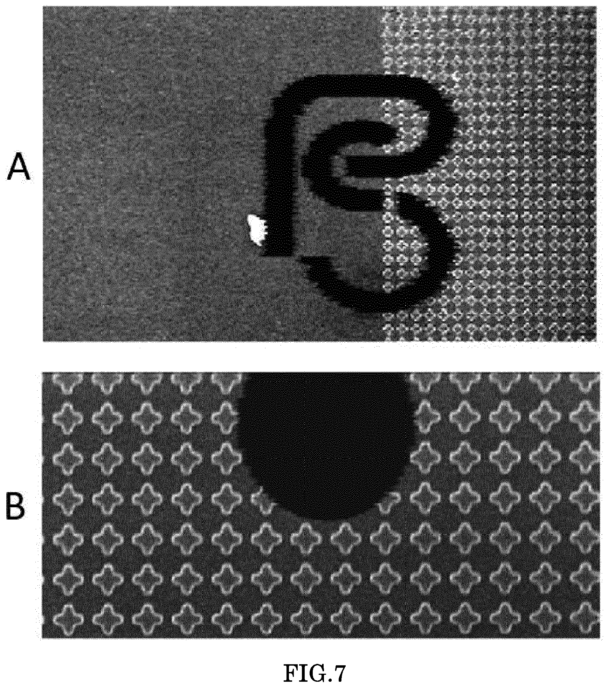

A sample having an unevenness pattern formed on a part of the surface was prepared and set in the SEM. The number of emission times of the electron beam B was set by the control unit 5 taking the measuring magnification, the size of the electron beam B, the irradiation region, and the like into consideration. Note that the intensity of the electron beam B (the intensity of the electron beam B was zero (no irradiation with excitation light L) or the intensity was constant) was used for the parameter, and the parameter was set taking the order of the emission times into consideration so that portions where the intensity of the electron beam B was zero were shaped in a logo of PeS on the sample. Next, the sample was irradiated with the electron beam B, and an image thereof was captured while the component of the electron gun 1 was being controlled so as to have the set parameter. FIG. 7A illustrates a resulted captured image. As illustrated in FIG. 7A, the image of the sample was captured for the portion irradiated with the electron beam B, and images of portions with unevenness formation and portions without unevenness formation were also clearly captured. Further, since an image of the sample was unable to be captured for portions where the intensity of the electron beam B was zero, these portions became black. As illustrated in FIG. 7A, because the black logo of PeS was observed, it was confirmed that a desired location on the sample can be irradiated with the electron beam B having a desired parameter by using the component on the electron gun 1 side. Note that, when a parameter defining that a part of the irradiation region R is not irradiated with the electron beam B as illustrated in Example 3 is set, deterioration of the photocathode 3 can be prevented compared to a case where irradiation with the electron beam B of the same intensity is continued, and this achieves an advantageous effect of being able to extend the lifetime of the photocathode 3.

### <Example 4>

Next, based on the resulted captured image in FIG. 7A displayed on the information display device, an image capturing region (irradiation region) was set so that magnified image capturing can be performed on a portion having the unevenness pattern, and the number of emission times of the electron beam B was set by the control unit 5. Note that, although the parameter of the electron beam B was set in Example 3 so that the logo of PeS can be formed, the parameter was set taking the order of emission times into consideration in Example 4 so that the irradiation region where the intensity of the electron beam B was zero became substantially semicircular. FIG. 7B illustrates a resulted captured image. As illustrated in FIG. 7B, for the portion irradiated with the electron beam B, an image of a magnified portion with unevenness formation of the sample was captured, and the portion where the intensity of the electron beam B was zero became substantially semicircular. In the example illustrated FIG. 7B, the parameters included only two types of changes in the intensity of the electron beam B, and the desired location on the sample was irradiated with the electron beam B having the desired parameter. Therefore, it was confirmed that it is possible to set the parameter in more detail by referencing information on the counterpart device E.

### [Industrial Applicability]

The use of the electron gun, the electron beam applicator, and the emission method of an electron beam disclosed in the present application can have a setting to make it possible to irradiate a desired location on an irradiation target with an electron beam having a desired electron beam parameter by using the component on the electron gun side. Therefore, the electron gun, the electron beam applicator, and the emission method of an electron beam disclosed in the present application are useful for business entities that handle an electron gun.

### [List of References]

- 1, 1A to 1D: electron gun
- 2: light source
- 3: photocathode (cathode)
- 4: anode
- 5: control unit
- 6: information display device
- 7: detector
- 10: electron beam deflector
- 51: light amount adjustment device
- 52: excitation light size adjustment device
- 53: electron beam size adjustment device
- 54: intermediate electrode
- 55: electron beam shape adjustment device
- B: electron beam
- CB: vacuum chamber
- L: excitation light
- R: irradiation region

## Claims

1. An electron gun comprising:
a light source;
a photocathode configured to generate releasable electrons in response to receiving light from the light source;
an anode configured to generate an electric field between the photocathode and the anode, extract the releasable electrons by the generated electric field, and form an electron beam; and
a control unit,
wherein the control unit
sets the number of emission times of the electron beam and sets an electron beam parameter for each emitting electron beam, or
sets an emission duration of the electron beam and sets an electron beam parameter of an emitting electron beam in association with the emission duration.

2. The electron gun according to claim 1,
wherein the control unit sets the number of emission times of the electron beam and sets an electron beam parameter for each emitting electron beam, and
wherein the electron beam parameter includes at least one selected from an intensity of an electron beam, a level of acceleration energy of an electron beam, a size of an electron beam, a shape of an electron beam, an emission duration of an electron beam, and an emittance of an electron beam.

3. The electron gun according to claim 2,
wherein the number of emission times is two or greater, and
wherein the control unit performs control such that at least one electron beam parameter differs from one selected from the remaining electron beam parameters when emitting an electron beam the set number of times.

4. The electron gun according to claim 1,
wherein the control unit sets an emission duration of the electron beam and sets an electron beam parameter of an emitting electron beam in association with the emission duration, and
wherein the electron beam parameter includes at least one selected from an intensity of an electron beam, a level of acceleration energy of an electron beam, a size of an electron beam, a shape of an electron beam, and an emittance of an electron beam.

5. The electron gun according to claim 4, wherein the control unit performs control such that the duration includes durations to emit the electron beams with the different parameters when emitting electron beams in the set emission duration.

6. The electron gun according to any one of claims 1 to 5, wherein two or more different locations on the photocathode are irradiated with excitation light from light source so that two or more electron beams are extracted from the photocathode.

7. An electron beam applicator including the electron gun according to any one of claims 1 to 6, wherein the electron beam applicator is:
a free electron laser accelerator,
an electron microscope,
an electron holography device,
an electron beam drawing device,
an electron diffractometer,
an electron beam inspection device,
an electron beam metal additive manufacturing device,
an electron beam lithography device,
an electron beam processing device,
an electron beam curing device,
an electron beam sterilization device,
an electron beam disinfection device,
a plasma generation device,
an atomic element generation device,
a spin-polarized electron beam generation device,
a cathodoluminescence device, or
an inverse photoemission spectroscopy device.

8. An emission method of an electron beam,
wherein the electron beam is emitted from an electron gun including
a light source,
a photocathode configured to generate releasable electrons in response to receiving light from the light source,
an anode configured to generate an electric field between the photocathode and the anode, extract the releasable electrons by the generated electric field, and form an electron beam, and
a control unit, and
wherein the control unit is configured to
set the number of emission times of the electron beam and set an electron beam parameter for each emitting electron beam, or
set an emission duration of the electron beam and set an electron beam parameter of an emitting electron beam in association with the emission duration,
the emission method comprising:
an electron beam emission step of forming an electron beam by irradiating the photocathode with excitation light from the light source and extracting releasable electrons generated by the photocathode in response to receiving the excitation light by using an electric field generated between the photocathode and the anode,
wherein control unit performs control in the electron beam emission step such that an emitting electron beam has the set electron beam parameter.

9. The emission method according to claim 8,
wherein the control unit is configured to set the number of emission times of the electron beam and set an electron beam parameter for each emitting electron beam, and
wherein the electron beam parameter includes at least one selected from an intensity of an electron beam, a level of acceleration energy of an electron beam, a size of an electron beam, a shape of an electron beam, an emission duration of an electron beam, and an emittance of an electron beam.

10. The emission method according to claim 9,
wherein the number of emission times is two or greater, and
wherein the control unit performs control such that at least one electron beam parameter differs from one selected from the remaining electron beam parameters when emitting an electron beam the set number of times.

11. The emission method according to claim 8,
wherein the control unit is configured to set an emission duration of the electron beam and set an electron beam parameter of an emitting electron beam in association with the emission duration, and
wherein the electron beam parameter includes at least one selected from an intensity of an electron beam, a level of acceleration energy of an electron beam, a size of an electron beam, a shape of an electron beam, and an emittance of an electron beam.

12. The emission method according to claim 11, wherein the control unit performs control such that the duration includes durations to emit electron beams with different parameters when emitting electron beams in the set emission duration.
